# EUROPÄISCHE PATENTSCHRIFT

(11) **EP 3 267 501 B1**
(45) Veröffentlichungstag und Bekanntmachung des Hinweises auf die Patenterteilung: **19.12.2018**
(21) Anmeldenummer: 17183329.6
(22) Anmeldetag: 26.07.2017
(51) Int. Cl.: H01L 33/64, H05K 1/02

(54) **BESTÜCKUNG VON THERMISCH HOCHLEITFÄHIGEN BAUTEILEN ZUR WÄRMESPREIZUNG**
MOUNTING OF THERMALLY HIGHLY CONDUCTIVE COMPONENTS FOR HEAT DISSIPATION
MONTAGE DE COMPOSANTS À CONDUCTIBILITÉ THERMIQUE ÉLEVÉE POUR DIFFUSION DE CHALEUR

(30) Priorität: 06.07.2016 AT 505992016
(43) Veröffentlichungstag der Anmeldung: 10.01.2018
(73) Patentinhaber: ZKW Group GmbH, 3250 Wieselburg (AT)
(72) Erfinder: Edlinger, Erik, 1090 Wien (AT)
(74) Vertreter: Patentanwaltskanzlei Matschnig & Forsthuber OG

(56) Entgegenhaltungen:
- US-A1- 2002 047 193
- US-A1- 2007 242 462
- US-A1- 2011 180 819

## Beschreibung

Die Erfindung betrifft eine Schaltungsanordnung, gemäß Anspruch 1, umfassend
- eine Leiterplatte,
- zumindest eine an der Leiterplatte befestigte Lichtquelle, sowie
- zumindest einen metallischen Wärmeleitkörper.

Zudem betrifft die Erfindung im Speziellen eine Leuchtvorrichtung, gemäß Anspruch 17, mit zumindest einer erfindungsgemäßen Schaltungsanordnung sowie einen Scheinwerfer gemäß Anspruch 18, insbesondere Kraftfahrzeugscheinwerfer, umfassend eine erfindungsgemäße Schaltungsanordnung und/ oder eine erfindungsgemäße Leuchtvorrichtung.

In vielen Anwendungsgebieten, nicht zuletzt der Automobilindustrie, werden in Elektronikschaltkreisen immer höhere Wärmeeinträge durch steigende Packungsdichte und Komplexität erreicht. Diese abzuführen, führt zu hohen Leiterplattenkosten, da meist der Einsatz von FR4-Substraten (eine Klasse von schwer entflammbaren und flammenhemmenden Verbundwerkstoffen bestehend aus Epoxidharz und Glasfasergewebe, das häufig als elektrisch nicht leitendes Trägermaterial bei elektrischen Leiterplatten eingesetzt wird) nicht ausreicht. Der Umstieg auf IMS (Insulated metal substrate) Leiterplatten war bisher bei Anwendungen mit hohen thermischen Anforderungen häufig notwendig, wodurch erhöhte Kosten verursacht werden.

Solche Anordnungen sind z.B. aus US2011/0180819 A1, US2007/0242462 A1, oder US2002/0047193 A1 bekannt.

Es wurde festgestellt, dass bei Anwendungen, in denen Lichtquellen auf einer Leiterplatte befestigt bzw. betrieben werden, in erster Linie die Lichtquellen die an der Leiterplatte anfallende Verlustwärme erzeugen und deshalb abhängig von der Anzahl der Lichtquellen lediglich ein einziger oder wenige Hotspots, also Orte mit stark erhöhter thermischer Belastung, auf einer solchen Leiterplatte existieren. Bisher war es in solchen Fällen unter Umständen notwendig, kostenintensives IMS-Leiterplattenmaterial zur Ableitung der Wärme von den Lichtquellen einzusetzen.

Eine Aufgabe der Erfindung besteht daher darin, eine alternative Möglichkeit zu schaffen, mit der Wärme der zumindest einen Lichtquelle kostengünstig und effizient verteilt werden kann.

Diese Aufgabe wird mit einer Schaltungsanordnung der eingangs genannten Art gelöst, bei welcher erfindungsgemäß die Lichtquelle sowie der Wärmeleitkörper als SMD-Bauteil ausgeführt sind, wobei die Lichtquelle zumindest zwei Kontaktflächen zur Kontaktierung der Leiterplatte aufweist und der Wärmeleitkörper zumindest eine Kontaktfläche zur Kontaktierung der Leiterplatte aufweist, wobei die Leiterplatte zu den zumindest zwei Kontaktflächen der Lichtquelle sowie zu der zumindest einen Kontaktfläche des Wärmeleitkörpers korrespondierende Kontaktflächen aufweist, wobei die zumindest zwei Kontaktflächen der Lichtquelle mit den korrespondierenden Kontaktflächen der Leiterplatte mittels jeweils einer Lötverbindung verbunden sind, und die zumindest eine Kontaktfläche des Wärmeleitkörpers mit der korrespondierenden Kontaktfläche der Leiterplatte mittels zumindest einer Lötverbindung verbunden ist, wobei zumindest eine Lötverbindung der Lichtquelle mit zumindest einer Lötverbindung des Wärmeleitkörpers zur Übertragung von Wärme zwischen der Lichtquelle und dem Wärmeleitkörper als gemeinsame Lötverbindung ausgeführt ist.

Der Ausdruck "SMD" ist ein Fachbegriff auf dem Gebiet der Elektronik, nämlich eine Abkürzung des englischsprachigen Begriffs "surface-mount device", zu Deutsch: "oberflächenmontiertes Bauteil. Dabei handelt es sich um Bauteile, die mittels entsprechend angeordneten elektrischen Kontakten die Oberfläche eines Schaltungsträgers bzw. einer Printplatte kontaktieren können. Der Schaltungsträger kann mit zu den elektrischen Kontakten des SMD-Bauteils korrespondierenden Kontakten ausgestattet sein, sodass die SMD-Bauteile an der Oberfläche des Schaltungsträgers mittels Lötverbindungen befestigt und elektrisch kontaktiert werden können. Ebenso können einzelne Kontakte als rein thermische Kontaktflächen ausgebildet sein. Auch ist es nicht zwingend erforderlich, dass die zumindest eine Kontaktfläche des SMD-Bauteils, die die gemeinsame Lötverbindung kontaktiert, eine elektrische Funktion erfüllt. Dies kann zwar vorgesehen sein, ist aber für die Wärmeleitung hin zu dem Wärmeleitkörper nicht erforderlich.

Unter dem Ausdruck "gemeinsame Lötverbindung" wird in Bezug auf die Komponenten A und B eine Lötverbindung verstanden, die sich von einem Kontakt der Komponenten A bis hin zu einem Kontakt der Komponente B durchgängig erstreckt. Dadurch ist es möglich, dass Wärme durchgängig entlang der gemeinsamen Lötverbindung (also innerhalb des Lots) zwischen den Komponenten A und B ausgetauscht werden kann, sodass die Temperaturdifferenzen zwischen A und B effektiv reduziert werden können. Bei der Komponente A handelt es sich beispielsweise um eine Lichtquelle, bei der Komponente B beispielsweise um den Wärmeleitkörper. Zusätzlich können ebenso gemeinsame Lötverbindungen zwischen anderen Komponenten vorgesehen sein. Das Vorsehen einer gemeinsamen Lötverbindung erlaubt einen übergangsfreien Wärmetransport zwischen den Kontaktflächen der beteiligten Komponenten.

Es wurde festgestellt, dass bei Lichtquellen der Bereich der lichtemittierenden Fläche sich im Betrieb der Lichtquelle besonders stark erwärmen kann. Zur optimierten Kühlung der Lichtquelle und zur Vermeidung von ausgeprägten Temperaturspitzen an der Lichtquelle kann daher vorgesehen sein, dass die Lichtquelle eine lichtemittierende Fläche aufweist, wobei die gemeinsame Lötverbindung zumindest jene Kontaktfläche der Lichtquelle erfasst, die der lichtemittierenden Fläche am nächsten liegt bzw. dem zur thermischen Ableitung vorgesehen Pad entspricht.

Zudem kann vorgesehen sein, dass die Höhe der gemeinsamen Lötverbindung zumindest 50 Mikrometer mm beträgt, wobei die Höhe normal zur durch die Leiterplatte aufgespannte Ebene gemessen wird.

Insbesondere kann vorgesehen sein, dass der Wärmeleitkörper ausschließlich aus Aluminium, Kupfer, Silber, metallisch beschichtetem Kohlenstoff, metallisch beschichtetem Silizium oder Verbindungen davon besteht.

Insbesondere kann es günstig sein, wenn der Wärmeleitkörper elektrisch leitfähig ist. Dadurch können einzelne Kontakte des Schaltungsträgers über den Wärmeleitkörper miteinander verbunden werden, wodurch sich beispielsweise ein Leiterplattenlayout vereinfache könnte, indem Kreuzungen von Leiterbahnen vermieden werden können.

Um die Lötverbindung besonders stabil mit der Leiterplatte zu verbinden sowie die Wärmeleitfähigkeit parallel zur Lötverbindung weiter zu verbessern, kann vorgesehen sein, dass die Leiterplatte zumindest eine der gemeinsamen Lötverbindung zugeordnete durchgängige Kontaktfläche aufweist, die sich von der Lichtquelle bis hin zu dem Wärmeleitkörper erstreckt und die Lichtquelle mit dem Wärmeleitkörper verbindet. Die Lötverbindung kann sich dabei mit der Kontaktfläche, die beispielsweise als Kupferfläche ausgebildet ist, verbinden.

Zudem kann vorgesehen sein, dass die Leiterplatte mehrere voneinander getrennte Kontaktflächen aufweist, die der Wärmeleitkörper mittels einer oder mehr Lötverbindungen kontaktiert, wodurch die Wärmeübertragung ausgehend von unterschiedlichen Kontaktflächen bzw. hin zu unterschiedliche Kontaktflächen erfolgen kann.

Weiters kann vorgesehen sein, dass die Lichtquelle eine Laserdiode und/oder eine LED aufweist.

Besonders günstig kann es sein, wenn die Breite b zumindest 0,8 mm, die Tiefe t zumindest 1 mm und die Höhe h zumindest 0,3 mm beträgt.

Insbesondere kann vorgesehen sein, dass der Wärmeleitkörper quaderförmig ausgebildet ist, wodurch eine besonders effiziente und günstig befestigbare Ausgestaltung des Wärmeleitkörpers gegeben ist.

Zudem kann vorgesehen sein, dass die Leiterplatte zumindest ein Via aufweist, wobei das zumindest eine Via vorzugsweise mit Lot gefüllt ist und mittels einer Lötverbindung mit dem Wärmeleitkörper verbunden ist. Dabei kann es günstig sein, wenn das zumindest eine Via die Leiterplatte vollständig durchsetzt. Insbesondere kann vorgesehen sein, dass sich das zumindest eine Via ausgehend von der gemeinsamen Lötverbindung der Lichtquelle mit dem Wärmeleitkörper in die Leiterplatte erstreckt. Zudem kann es günstig sein, wenn das zumindest eine Via als Slot-Via ausgeführt ist, indem das zumindest eine Via als ein die Leiterplatte durchsetzender Kanal ausgeführt ist, wobei sich der Kanal zumindest 2 mm, vorzugsweise zwischen 6 und 20 mm, entlang der Ebene der Leiterplatte erstreckt. Natürlich ist es möglich, mehr als ein Via vorzusehen. So können beispielsweise zwei, drei, vier oder mehr Vias vorgesehen, die als Slot-Via oder auch als herkömmliches Via ausgebildet sein können.

Zur zusätzlichen Verbesserung des thermischen Managements der Schaltungsanordnung kann vorgesehen sein, dass die Schaltungsanordnung einen weiteren Wärmeleitkörper aufweist. Im Prinzip kann eine beliebige Anzahl an Lichtquellen und oder wärmeleitender Körper vorgesehen sein. Unter dem Begriff Anzahl wird im Rahmen dieser Offenbarung - sofern nicht anders angegeben - eine Anzahl verstanden, die beispielsweise eins, zwei, drei, vier oder mehr, insbesondere sechs, acht, zehn, zwölf oder mehr als zwölf betragen kann. Der Fachmann ist in Anbetracht dieser Offenbarung in der Lage, die Anzahl der jeweiligen Elemente, entsprechend den technischen Anforderungen zu wählen.

Insbesondere kann vorgesehen sein, dass weiterer Wärmeleitkörper mit einem weiteren elektrischen Kontakt der Lichtquelle mittels einer gemeinsamen Lötverbindung verbunden ist. Dementsprechend kann auch die Anzahl der gemeinsamen Lötverbindungen frei gewählt werden.

Auch kann es vorgesehen sein, dass die Schaltungsanordnung einen weiteren Wärmeleitkörper aufweist, der an der der Lichtquelle gegenüberliegenden Seite der Leiterplatte angeordnet ist und mittels zumindest eines die Leiterplatte durchsetzenden lotgefüllten Vias mit der Lichtquellenseite der Leiterplatte thermisch verbunden ist.

Insbesondere kann vorgesehen sein, dass die Leiterplatte aus FR-4 Substrat besteht oder als IMS-Leiterplatte ausgebildet ist. Eine erfindungsgemäße Schaltungsanordnung, bei der die Leiterplatte als IMS Material besteht, zwar kostenintensiv, kann allerdings eine in einem besonderen Ausmaß optimiertes thermisches Management aufweisen.

Weitere Aspekte der Erfindung betreffen eine Leuchtvorrichtung mit zumindest einer erfindungsgemäßen Schaltungsanordnung sowie einen Scheinwerfer, insbesondere einen Kraftfahrzeugscheinwerfer, umfassend eine erfindungsgemäße Schaltungsanordnung und/oder eine erfindungsgemäße Leuchtvorrichtung. Zudem betrifft ein Aspekt der Erfindung ein Fahrzeug mit einer erfindungsgemäßen Schaltungsanordnung und/oder einer erfindungsgemäßen Leuchtvorrichtung und/ oder einem erfindungsgemäßen Scheinwerfer.

Die Erfindung ist im Folgenden anhand beispielhafter und nicht einschränkender Ausführungsformen näher erläutert, die in den Figuren veranschaulicht sind. Darin zeigt
Figur 1 eine schematische Darstellung einer ersten Ausführungsform der Erfindung,
Figur 2 eine schematische Darstellung einer zweiten Ausführungsform der Erfindung,
Figur 3 eine schematische Darstellung einer dritten Ausführungsform der Erfindung,
Figuren 4(a) bis 4(f) unterschiedliche weitere Möglichkeiten zur Verbesserung der Wärmeleitfähigkeit einer Schaltungsanordnung.

In den folgenden Figuren bezeichnen - sofern nicht anders angegeben - gleiche Bezugszeichen gleiche Merkmale.

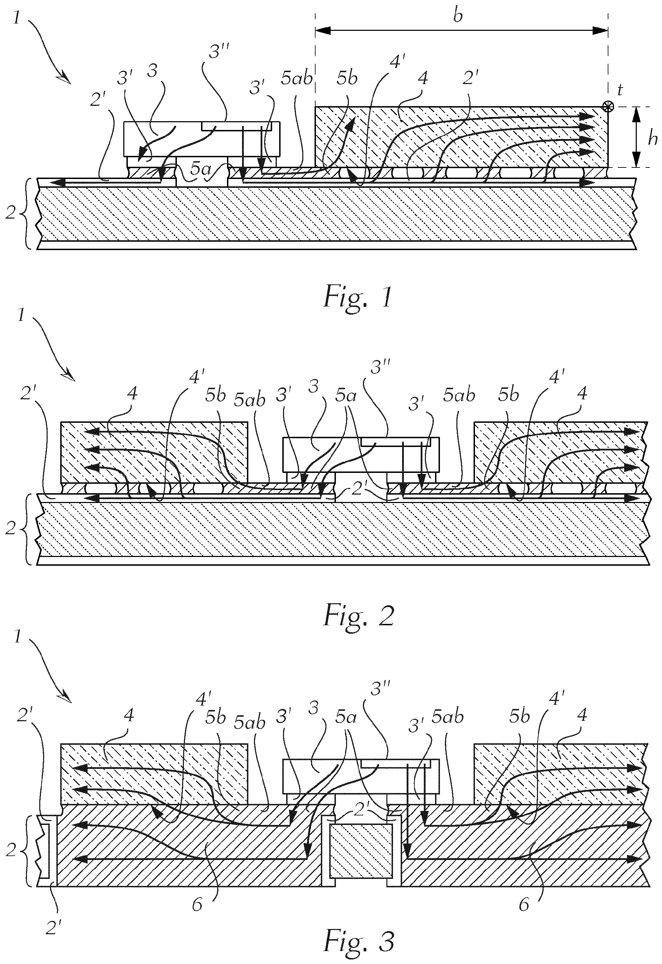

Figur 1 offenbart eine Schaltungsanordnung 1, umfassend eine Leiterplatte 2, zumindest eine an der Leiterplatte 2 befestigte Lichtquelle 3 sowie zumindest einen metallischen Wärmeleitkörper 4. Die Lichtquelle 3 sowie der Wärmeleitkörper 4 sind als SMD-Bauteile ausgeführt, wobei die Lichtquelle 3 zumindest zwei Kontaktflächen 3' zur Kontaktierung der Leiterplatte 2 aufweist und der Wärmeleitkörper 4 zumindest eine Kontaktfläche 4' zur Kontaktierung der Leiterplatte 2 aufweist. Im vorliegenden Ausführungsbeispiel ist die Kontaktfläche 4' an der gesamten der Leiterplatte 2 zugewandten Unterseite des Wärmeleitkörpers 4 ausgebildet. Die Leiterplatte 2 weist zu den zumindest zwei Kontaktflächen 3' der Lichtquelle 3 sowie zu der zumindest einen Kontaktfläche 4' des Wärmeleitkörpers 4 korrespondierende Kontaktflächen 2' auf.

Die zumindest zwei Kontaktflächen 3' der Lichtquelle 3 sind mit den korrespondierenden Kontaktflächen 2' der Leiterplatte 2 mittels jeweils einer Lötverbindung 5a verbunden, wobei die zumindest eine Kontaktfläche 4' des Wärmeleitkörpers 4 mit der korrespondierenden Kontaktfläche 2' der Leiterplatte 2 mittels zumindest einer Lötverbindung 5b verbunden ist, wobei zumindest eine Lötverbindung 5a der Lichtquelle 3 mit zumindest einer Lötverbindung 5b des Wärmeleitkörpers 4 zur Übertragung von Wärme zwischen der Lichtquelle 3 und dem Wärmeleitkörper 4 als gemeinsame Lötverbindung 5ab ausgeführt ist.

Dadurch ist es möglich, das Wärme, die in den Figuren durch Pfeile dargestellt ist, von einer Kontaktfläche 3' der Lichtquelle 3 (im vorliegenden Beispiel die rechte Kontaktfläche 3') innerhalb der gemeinsamen Lötverbindung 5ab durchgängig hin zu der Kontaktfläche 4' des Wärmeleitkörpers 4 übertragen werden kann. Die Lötverbindung 5ab weist typischerweise eine Höhe von zumindest 50 Mikrometer auf, wodurch sich Wärme besonders wirksam von der Lichtquelle hin zu dem Wärmeleitkörper 4 übertragen lässt. Der Wärmeleitkörper 4 kann zur verbesserten Abgabe von Wärme über Kühlrippen verfügen.

Die Lichtquelle 3 weist eine lichtemittierende Fläche 3" auf, wobei die gemeinsame Lötverbindung 5ab zumindest jene Kontaktfläche 3' der Lichtquelle 3 erfasst, die der lichtemittierenden Fläche 3"am nächsten liegt.

Der Wärmeleitkörper 4 kann beispielsweise aus Aluminium, Kupfer, Silber, Zinn, metallische beschichteter Kohlenstoff oder Silizium oder Verbindungen der vorgenannten Materialien bestehen. Die Verwendung von Kupfer ist aufgrund seiner ausgezeichneten Wärmeleitfähigkeit sowie seines geringen Wärmedehnungskoeffizienten besonders vorteilhaft.

Wie in Figur 1 erkennbar, ist gegenüberliegend zur rechten Kontaktfläche 3' der Lichtquelle 3 an der Leiterplatte 2 eine Kontaktfläche 2' ausgebildet, die sich bis hin zu dem wärmeleitenden Körper 4 und an diesem entlang erstreckt. Die gemeinsame Lötverbindung 5ab kann damit besonders großflächig ausgebildet werden, wobei die gemeinsame Lötverbindung 5ab fest mit der Kontaktfläche 2' verbunden sein kann. Alternativ dazu kann vorgesehen sein, dass Leiterplatte 2 mehrere voneinander getrennte Kontaktflächen 2' aufweist, die der Wärmeleitkörper 4 mittels einer oder mehrerer Lötverbindungen 5b kontaktiert. Sofern der Wärmeleitkörper 4 elektrisch leitfähig ausgebildet ist, kann zusätzlich zur Wärmeverteilung zwischen den Kontaktflächen 2' eine elektrische Verbindung dieser Kontaktflächen 2' realisiert werden. Als Lichtquellen 3 können beispielsweise Laserdioden und/ oder LEDs eingesetzt werden. Der Wärmeleitkörper 4 weist vorzugsweise eine Breite b zwischen 3 mm und 20 mm eine Höhe h zwischen 0,3 mm und 2 mm und eine Tiefe t zwischen 1 mm und 10 mm auf, wobei die Tiefe in Normalrichtung zur durch die Breite und Höhe aufgespannte Ebene gemessen wird. Vorzugsweise ist der wärmeleitende Körper 4 quaderförmig ausgebildet, wobei die Breite b und Tiefe t die Grundfläche des Quaders festlegen und die Höhe h der Höhe des Quaders entspricht.

Figur 2 zeigt eine schematische Darstellung einer zweiten Ausführungsform der Erfindung, bei der im Gegensatz zur Ausführungsform gemäß Figur 1 zwei Wärmeleitkörper 4 vorgesehen sind, die an gegenüberliegenden Seiten der Lichtquelle 3 angeordnet sind, wobei beide Wärmeleitkörper 4 über jeweils eine gemeinsame Lötverbindung 5ab mit der Lichtquelle 3 verbunden sind. Die Wärmeverteilung an der Schaltungsanordnung 1 lässt sich damit zusätzlich verbessern.

Figur 3 zeigt eine schematische Darstellung einer dritten Ausführungsform der Erfindung, wobei im Gegensatz zu den zuvor genannten Ausführungsformen in der Leiterplatte 2 jeweils zwei den Kontaktflächen 3' der Lichtquelle 3 zugeordnete Via in Form von Slot-Via 6 ausgebildet sind. Ein Slot-Via 6 ist durch eine kanalartige Ausnehmung in der Leiterplatte 2 ausgebildet, die die Leiterplatte 2 auch vollständig durchsetzen kann. Diese Ausnehmung erstreckt sich in den vorliegen Beispiel jeweils hin zu dem Wärmeleitkörper 4 und ist dazu eingerichtet, bei Anbringen der gemeinsamen Lötverbindung 5ab mit dem eingebrachten Lot verbunden bzw. ausgefüllt zu werden. Zu diesem Zwecke können die Innenwände der Kanäle beispielsweise mit Kupfer beschichtet sein, sodass das Lot die Kanäle effizient ausfüllen kann und durch kapillare Kräfte in die Kanäle hineingezogen werden kann, wodurch die Kanäle vollständig mit dem Lot ausgefüllt werden können. Die mit dem Lot der gemeinsamen Lötverbindung 5ab gefüllten Slot-Vias 6 ermöglichen eine Wärmeübertragung in das Innere der Leiterplatte 2 und durch diese hindurch, wobei beispielsweise auch an der der Lichtquelle 3 gegenüberliegenden Seite Maßnahmen zur thermischen Optimierung der Schaltungsanordnung 1 vorgesehen sein können, um in die Leiterplatte 2 eingebrachte Wärme nach außen abzuleiten. So könnten die Slot-Via 6 an der der Lichtquelle 3 gegenüber liegenden Seite der Leiterplatte 2 ebenso weitere in den Figuren nicht dargestellte Wärmeleitkörper kontaktieren. Im vorliegenden Beispiel geht die Beschichtung an den Innenwänden der Slot-Vias 6 an der gegenüberliegenden Seite der Leiterplatte 2 in eine Leiterbahnkontaktfläche 2' über. Alternativ dazu könnte allerdings ebenso eine Isolierschicht vorgesehen sein oder beispielsweise ein Kühlkörper angebracht und mit dem Slot-Via verbunden werden.

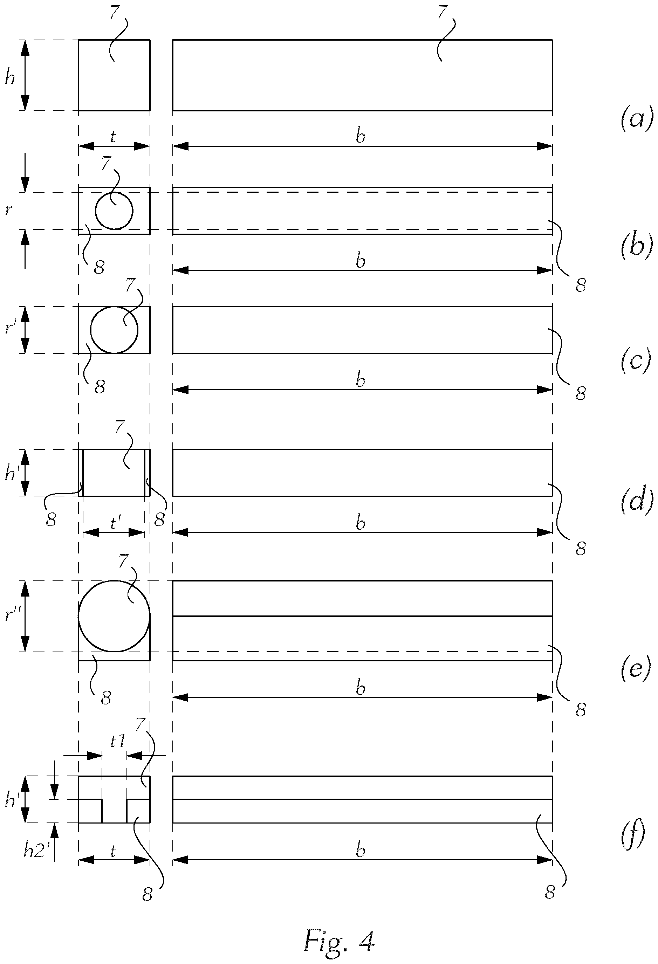

Die Figuren 4(a) bis 4(f) zeigen unterschiedliche weitere Möglichkeiten zur Verbesserung der Wärmeleitfähigkeit einer Schaltungsanordnung 1 jeweils in einer vorderen und einer seitlichen Schnittdarstellung eines in einer Leiterplatte 2 (nicht dargestellt) einzubettenden Wärmeleitkörpers 7. Zu diesem Zweck können Wärmeleitkörper 7 in die Leiterplatte 2 eingebracht werden. Bei den Wärmeleitkörpern 7 kann es sich beispielsweise um Kupferkörper handeln, die in der Leiterplatte 2 vorgesehene Öffnungen bzw. Vertiefungen eingesetzt werden, wobei die Vertiefungen mittels Lot ausgefüllt werden können, indem die Wärmeleitkörper 7 mittels einer Lötverbindung 8 mit der Leiterplatte 2 fest verbunden werden. Die Seitenwände der Öffnungen bzw. Vertiefungen sind vorzugsweise mit Kupfer beschichtet, um eine feste Verbindung des Lots mit der Öffnung bzw. Vertiefung sowie einen effektiven Wärmeübergang zu ermöglichen. Die Figuren 4a bis 4f zeigen unterschiedliche Anordnungen dieser Art und können als zusätzliche Maßnahme zur Optimierung des thermischen Managements der Schaltungsanordnung 1 vorgesehen sein, setzen allerdings eine entsprechende Vorbereitung der Leiterplatte 2 voraus, wodurch sich die Kosten einer solchen Leiterplatte 2 erhöhen können. Im Prinzip können diese in die Leiterplatte integrierbaren Wärmeleitkörper 7 auch unabhängig von den Ausführungsformen gemäß den Figuren 1 bis 3 vorgesehen sein. Sie setzen also nicht das Vorhandensein von als SMD-Bauteil ausgeführten Wärmeleitkörpern 4 gemäß den Figuren 1 bis 3 voraus. Insbesondere kann vorgesehen sein, dass die Wärmeleitkörper 7 nach Fig. 4 z.B. durch Slot-Vias kontaktiert werden, die wiederum mit einem oberflächenmontierten Wärmeleitkörper 4 nach Fig. 1 bis 3 und einer gemeinsamen Lötverbindung 5ab in Verbindung stehen.

Allgemein kann gesagt werden, dass durch die metallische Verbindung von Lot mit einem Wärmeleitkörper und einer Kupferspreizfläche darunter eine verbesserte thermische Kopplung von dem Wärmeleitkörper und einer Wärmequelle, beispielsweise der Lichtquelle 3, erreicht werden kann. Durch das Vorsehen gemeinsamer Lötverbindungen 5ab gemäß der Erfindung muss lediglich der geringe thermische Übergangswiderstand des Lots überwunden werden. Die thermische Leitfähigkeit von Kupfer beträgt bis zu 401 W/mK, für Aluminium hingegen beträgt sie nur bis zu 236 W/mK. Zusätzlich zu diesem Aufbau kann für Aufbauten mit Kühlkörpern ein Langloch direkt unter dem Kupferbauteil vorgesehen werden, bzw. das Bauteil im Langloch versenkt eingelötet werden, um einen direkten Wärmeübergang an die Unterseite der Leiterplatte zu ermöglichen. Der Wärmeleitkörper 7 kann selbst vollständig oder teilweise mit niedrigschmelzendem Lot bedeckt sein, wobei durch Vorsehen eines niedrigschmelzenden Lots ein homogenes Einlöten erleichtert wird.

Den meisten fachkundigen Elektronikern ist die hohe Wärmeleitfähigkeit von Kupfer in fester Form bekannt. Es wird bei High-Power Anwendungen zur Spreizung der Wärme entlang der FR4- bzw. IMS- Oberflächen genutzt. Jedoch ist jeder zusätzliche Mikrometer Kupfer auf einem Leiterplattensubstrat galvanisch aufgewachsen und hat am gesamten Substrat die gleiche Dicke. Dies führt neben dem erhöhten Preis des Substrates bei Fine-Pitch Strukturen zu Problemen des Leiterbahnmindestabstandes aufgrund der isotropen Ab-scheidemethode im nasschemischen Herstellungsprozess der Leiterplatte. Es ist daher deutlich kostengünstiger und einfacher, die zuvor angeführten Maßnahmen zur Verbesserung der Wärmeleitfähigkeit vorzusehen.

In Anbetracht dieser Lehre ist der Fachmann in der Lage, ohne erfinderisches Zutun zu anderen, nicht gezeigten Ausführungsformen der Erfindung zu gelangen. Die Erfindung ist daher nicht auf die gezeigten Ausführungsformen beschränkt. Auch können einzelne Aspekte der Erfindung bzw. der Ausführungsformen aufgegriffen und miteinander kombiniert werden. Wesentlich sind die der Erfindung zugrunde liegenden Gedanken, die durch einen Fachmann in Kenntnis dieser Beschreibung in mannigfaltiger Weise ausgeführt werden können und trotzdem als solche aufrechterhalten bleiben.

Der Umfang der Erfindung wird ausschließlich durch die beigefügten Ansprüche definiert.

## Patentansprüche

1. Schaltungsanordnung (1) umfassend
- eine Leiterplatte,
- zumindest eine an der Leiterplatte (2) befestigte Lichtquelle (3), sowie
- zumindest einen metallischen Wärmeleitkörper (4),
wobei die Lichtquelle (3) sowie der Wärmeleitkörper (4) als SMD-Bauteile ausgeführt sind, wobei die Lichtquelle (3) zumindest zwei Kontaktflächen (3') zur Kontaktierung der Leiterplatte (2) aufweist und der Wärmeleitkörper (4) zumindest eine Kontaktfläche (4') zur Kontaktierung der Leiterplatte (2) aufweist, wobei die Leiterplatte (2) zu den zumindest zwei Kontaktflächen (3') der Lichtquelle (3) sowie zu der zumindest einen Kontaktfläche (4') des Wärmeleitkörpers (4) korrespondierende Kontaktflächen (2') aufweist, wobei die zumindest zwei Kontaktflächen (3') der Lichtquelle (3) mit den korrespondierenden Kontaktflächen (2') der Leiterplatte (2) mittels jeweils einer Lötverbindung (5a) verbunden sind, und die zumindest eine Kontaktfläche (4') des Wärmeleitkörpers (4) mit der korrespondierenden Kontaktfläche (2') der Leiterplatte (2) mittels zumindest einer Lötverbindung (5b) verbunden ist,
**dadurch gekennzeichnet, dass** zumindest eine Lötverbindung (5a) der Lichtquelle (3) mit zumindest einer Lötverbindung (5b) des Wärmeleitkörpers (4) zur Übertragung von Wärme zwischen der Lichtquelle (3) und dem Wärmeleitkörper (4) als gemeinsame Lötverbindung (5ab) ausgeführt ist.

2. Schaltungsanordnung (1) nach Anspruch 1, wobei die Lichtquelle (3) eine lichtemittierende Fläche (3") aufweist, wobei die gemeinsame Lötverbindung (5ab) zumindest jene Kontaktfläche (5a) der Lichtquelle (3) erfasst, die der lichtemittierenden Fläche (3") am nächsten liegt.

3. Schaltungsanordnung (1) nach Anspruch 1 oder 2, wobei die Höhe der gemeinsamen Lötverbindung (5ab) zumindest 50 Mikrometer beträgt.

4. Schaltungsanordnung (1) nach einem der Ansprüche 1 bis 3, wobei der Wärmeleitkörper (4) ausschließlich aus Aluminium, Kupfer, Silber, metallisch beschichtetem Kohlenstoff, metallisch beschichtetem Silizium oder Verbindungen der vorgenannten Materialien besteht.

5. Schaltungsanordnung (1) nach einem der vorhergehenden Ansprüche, wobei der Wärmeleitkörper (4) elektrisch leitfähig ist.

6. Schaltungsanordnung (1) nach einem der vorhergehenden Ansprüche, wobei die Leiterplatte (2) zumindest eine der gemeinsamen Lötverbindung (5ab) der Lichtquelle (3) mit dem Wärmeleitkörper (4) zugeordnete durchgängige Kontaktfläche (2') aufweist, die sich von der Lichtquelle (3) bis hin zu dem Wärmeleitkörper (4) erstreckt.

7. Schaltungsanordnung (1) nach einem der vorhergehenden Ansprüche, wobei die Leiterplatte (2) mehrere voneinander getrennte Kontaktflächen (2') aufweist, die der Wärmeleitkörper (4) mittels einer oder mehr Lötverbindungen (5ab, 5b) kontaktiert.

8. Schaltungsanordnung (1) nach einem der vorhergehenden Ansprüche, wobei die Lichtquelle (3) eine Laserdiode und/ oder eine LED aufweist.

9. Schaltungsanordnung (1) nach einem der vorhergehenden Ansprüche, wobei die Breite b des Wärmeleitkörpers (4) zumindest 0,8 mm, die Tiefe t zumindest 1 mm und die Höhe h zumindest 0,3 mm beträgt.

10. Schaltungsanordnung (1) nach einem der vorhergehenden Ansprüche, wobei der Wärmeleitkörper (4) quaderförmig ausgebildet ist.

11. Schaltungsanordnung (1) nach einem der vorhergehenden Ansprüche, wobei die Leiterplatte (2) zumindest ein Via (6) aufweist, wobei das zumindest eine Via (6) vorzugsweise mit Lot gefüllt ist und mittels einer Lötverbindung mit dem Wärmeleitkörper (4) verbunden ist, wobei vorzugsweise das zumindest eine Via (6) die Leiterplatte (2) vollständig durchsetzt, wobei insbesondere vorgesehen ist, dass sich das zumindest eine Via (6) ausgehend von der gemeinsamen Lötverbindung (5ab), die die Lichtquelle (3) mit dem Wärmeleitkörper (4) verbindet, in die Leiterplatte (2) erstreckt.

12. Schaltungsanordnung (1) nach Anspruch 11, wobei das zumindest eine Via (6) als Slot-Via (6) ausgeführt ist, indem das zumindest eine Via (6) als ein die Leiterplatte (2) durchsetzender Kanal ausgeführt ist, wobei sich der Kanal zumindest 2 mm, vorzugsweise zwischen 6 und 20 mm, entlang der Ebene der Leiterplatte (2) erstreckt.

13. Schaltungsanordnung (1) nach einem der vorhergehenden Ansprüche, wobei die Schaltungsanordnung (1) einen weiteren Wärmeleitkörper (4) aufweist.

14. Schaltungsanordnung (1) nach einem der vorhergehenden Ansprüche, wobei ein weiterer Wärmeleitkörper (4) mit einem weiteren elektrischen Kontakt (3') der Lichtquelle (3) mittels einer gemeinsamen Lötverbindung (5ab) verbunden ist.

15. Schaltungsanordnung (1) nach einem der vorhergehenden Ansprüche, wobei die Schaltungsanordnung (1) einen weiteren Wärmeleitkörper (4) aufweist, der an der der Lichtquelle (3) gegenüberliegenden Seite der Leiterplatte (2) angeordnet ist und mittels zumindest eines die Leiterplatte (2) durchsetzenden lotgefüllten Vias (6) mit der Seite der Leiterplatte (2), an der die zumindest eine Lichtquelle (3) angeordnet ist, thermisch verbunden ist.

16. Schaltungsanordnung (1) nach einem der vorhergehenden Ansprüche, wobei die Leiterplatte (2) aus FR-4 Substrat besteht oder als IMS-Leiterplatte (2) ausgebildet ist.

17. Leuchtvorrichtung mit zumindest einer Schaltungsanordnung (1) nach einem der vorhergehenden Ansprüche.

18. Scheinwerfer, insbesondere Kraftfahrzeugscheinwerfer umfassend eine Schaltungsanordnung (1) nach einem der Ansprüche 1 bis 16 und/oder eine Leuchtvorrichtung nach Anspruch 17.

## Claims

1. A circuit assembly (1) comprising
- a printed circuit board,
- at least one light source (3) fastened to the printed circuit board (2), and
- at least one metal heat-conductive body (4),
wherein the light source (3) and the heat-conductive body (4) are designed as SMD components, wherein the light source (3) has at least two contact faces (3') for contacting the printed circuit board (2) and the heat-conductive body (4) has at least one contact face (4') for contacting the printed circuit board (2), wherein the printed circuit board (2) has contact faces (2') corresponding to the at least two contact faces (3') of the light source (3) and to the at least one contact face (4') of the heat-conductive body (4), wherein the at least two contact faces (3') of the light source (3) are connected to the corresponding contact faces (2') of the printed circuit board (2) in each case by means of a solder connection (5a), and the at least one contact face (4') of the heat-conductive body (4) is connected to the corresponding contact face (2') of the printed circuit board (2) by means of at least one solder connection (5b),
**characterised in that**
at least one solder connection (5a) of the light source (3) with at least one solder connection (5b) of the heat-conductive body (4) is designed as a common solder connection (5ab) for the transfer of heat between the light source (3) and the heat-conductive body (4).

2. The circuit assembly (1) according to claim 1, wherein the light source (3) has a light-emitting face (3''), wherein the common solder connection (5ab) contacts at least the contact face (3') of the light source (3) that lies closest to the light-emitting face (3").

3. The circuit assembly (1) according to claim 1 or 2, wherein the height of the common solder connection (5ab) is at least 50 micrometres.

4. The circuit assembly (1) according to any one of claims 1 to 3, wherein the heat-conductive body (4) consists exclusively of aluminium, copper, silver, metal-coated carbon, metal-coated silicon or compounds of the aforementioned materials.

5. The circuit assembly (1) according to any one of the preceding claims, wherein the heat-conductive body (4) is electrically conductive.

6. The circuit assembly (1) according to any one of the preceding claims, wherein the printed circuit board (2) has at least one continuous contact face (2') associated with the common solder connection (5ab) of the light source (3) with the heat-conductive body (4), which contact face extends from the light source (3) to the heat-conductive body (4).

7. The circuit assembly (1) according to any one of the preceding claims, wherein the printed circuit. board (2) has a plurality of contact faces (2') separate from one another, which contact the heat-conductive body (4) by means of one or more solder connections (5a, 5b).

8. The circuit assembly (1) according to any one of the preceding claims, wherein the light source (3) has a laser diode and/or an LED.

9. The circuit assembly (1) according to any one of the preceding claims, wherein the width b of the heat-conductive body (4) is at least 0.8 mm, the depth t is at least 1 mm, and the height h is at least 0.3 mm.

10. The circuit assembly (1) according to any one of the preceding claims, wherein the heat-conductive body (4) is cuboid.

11. The circuit assembly (1) according to any one of the preceding claims, wherein the printed circuit board (2) has at least one via (6), wherein the at least one via (6) is preferably filled with solder and is connected to the heat-conductive body (4) by means of a solder connection, wherein the at least one via (6) preferably penetrates fully through the printed circuit board (2), wherein in particular it is provided that the at least one via (6) extends starting from the common solder connection (5ab), which connects the light source (3) to the heat-conductive body (4), into the printed circuit board (2).

12. The circuit assembly (1) according to claim 11, wherein the at least one via (6) is designed as a slot via (6) in that the at least one via (6) is designed as a channel penetrating through the printed circuit board (2), wherein the channel extends at least 2 mm, preferably between 6 and 20 mm, along the plane of the printed circuit board (2).

13. The circuit assembly (1) according to any one of the preceding claims, wherein the circuit assembly (1) has a further heat-conductive body (4).

14. The circuit assembly (1) according to any one of the preceding claims, wherein a further heat-conductive body (4) is connected to a further electrical contact (3') of the light source (3) by means of a common solder connection (5ab).

15. The circuit assembly (1) according to any one of the preceding claims, wherein the circuit assembly (1) has a further heat-conductive body (4), which is arranged on the side of the printed circuit board (2) opposite the light source (3) and is thermally connected by means of at least one solder-filled via (6) penetrating through the printed circuit board (2) to the side of the printed circuit board (2) on which the at least one light source (3) is arranged.

16. The circuit assembly (1) according to any one of the preceding claims, wherein the printed circuit board (2) consists of FR-4 substrate or is formed as an IMS printed circuit board (2).

17. A lighting device having at least one circuit assembly (1) according to any one of the preceding claims.

18. A headlamp, in particular motor vehicle headlamp, comprising a circuit assembly (1) according to any one of claims 1 to 16 and/or a lighting device according to claim 17.

## Revendications

1. Circuit (1) comportant
- une carte de circuits imprimés ;
- au moins une source de lumière (3) fixée sur la carte de circuits imprimés (2) ; ainsi que
- au moins un corps métallique conducteur de chaleur (4),
la source de lumière (3) ainsi que le corps conducteur de chaleur (4) étant réalisés sous la forme de composants SMD, la source de lumière (3) présentant au moins deux surfaces de contact (3') pour l'établissement du contact avec la carte de circuits imprimés (2) et le corps conducteur de chaleur (4) présentant au moins une surface de contact (4') pour l'établissement du contact avec la carte de circuits imprimés (2), la carte de circuits imprimés (2) présentant des surfaces de contact (2') correspondant auxdites au moins deux surfaces de contact (3') de la source de lumière (3) ainsi qu'à ladite au moins une surface de contact (4') du corps conducteur de chaleur (4), lesdites au moins deux surfaces de contact (3') de la source de lumière (3) étant reliées avec les surfaces de contact (2') correspondantes de la carte de circuits imprimés (2) au moyen respectivement d'une liaison par brasage (5a), et ladite au moins une surface de contact (4') du corps conducteur de chaleur (4) étant reliée à la surface de contact (2') correspondante de la carte de circuits imprimés (2) au moyen d'au moins une liaison par brasage (5b),
**caractérisé par le fait que**
au moins une liaison par brasage (5a) de la source de lumière (3) est réalisée sous la forme d'une liaison par brasage commune (5ab) avec au moins une liaison par brasage (5b) du corps conducteur de chaleur (4) pour le transfert de chaleur entre la source de lumière (3) et le corps conducteur de chaleur (4).

2. Circuit (1) selon la revendication 1, dans lequel la source de lumière (3) présente une surface (3'') émettant de la lumière, la liaison par brasage commune (5ab) comprenant au moins la surface de contact (5a) de la source de lumière (3) qui se trouve le plus près de la surface (3'') émettant de la lumière.

3. Circuit (1) selon l'une des revendications 1 ou 2, dans lequel la hauteur de la liaison par brasage commune (5ab) s'élève à au moins 50 microns.

4. Circuit (1) selon l'une des revendications 1 à 3, dans lequel le corps conducteur de chaleur (4) est fait exclusivement d'aluminium, de cuivre, d'argent, de carbone à revêtement métallique, de silicium à revêtement métallique ou des composés des matières précitées.

5. Circuit (1) selon l'une des revendications précédentes, dans lequel le corps conducteur de chaleur (4) est conducteur de l'électricité.

6. Circuit (1) selon l'une des revendications précédentes, dans lequel la carte de circuits imprimés (2) présente au moins une surface de contact (2') continue associée à la liaison par brasage commune (5ab) de la source de lumière (3) avec le corps conducteur de chaleur (4), qui s'étend de la source de lumière (3) jusqu'au corps conducteur de chaleur (4).

7. Circuit (1) selon l'une des revendications précédentes, dans lequel la carte de circuits imprimés (2) présente plusieurs surfaces de contact (2') séparées les unes des autres, qui viennent en contact avec le corps conducteur de chaleur (4) au moyen d'une ou plusieurs liaisons par brasage (5ab, 5b).

8. Circuit (1) selon l'une des revendications précédentes, dans lequel la source de lumière (3) présente une diode laser et/ou une diode électroluminescente (LED).

9. Circuit (1) selon l'une des revendications précédentes, dans lequel la largeur b du corps conducteur de chaleur (4) s'élève à au moins 0,8 mm, la profondeur t, à au moins 1 mm, et la hauteur h, à au moins 0,3 mm.

10. Circuit (1) selon l'une des revendications précédentes, dans lequel le corps conducteur de chaleur (4) est réalisé en forme de parallélépipède.

11. Circuit (1) selon l'une des revendications précédentes, dans lequel la carte de circuits imprimés (2) présente au moins un trou d'interconnexion (6), ledit au moins un trou d'interconnexion (6) étant rempli de préférence par une brasure et étant relié au corps conducteur de chaleur (4) au moyen d'une liaison par brasage, de préférence ledit au moins un trou d'interconnexion (6) traversant entièrement la carte de circuits imprimés (2), en particulier étant prévu que ledit au moins un trou d'interconnexion (6) s'étende dans la carte de circuits imprimés (2) à partir de la liaison par brasage commune (5ab), qui relie la source de lumière (3) avec le corps conducteur de chaleur (4).

12. Circuit (1) selon la revendication 11, dans lequel ledit au moins un trou d'interconnexion (6) est réalisé sous la forme de trou d'interconnexion en fente (6), en ce que ledit au moins un trou d'interconnexion (6) est réalisé sous la forme d'un canal traversant la carte de circuits imprimés (2), le canal s'étendant sur au moins 2 mm, de préférence entre 6 et 20 mm, le long du plan de la carte de circuits imprimés (2).

13. Circuit (1) selon l'une des revendications précédentes, dans lequel le circuit (1) présente un corps conducteur de chaleur supplémentaire (4).

14. Circuit (1) selon l'une des revendications précédentes, dans lequel un corps conducteur de chaleur supplémentaire (1) est relié à un contact électrique supplémentaire (3') de la source de lumière (3) au moyen d'une liaison par brasage commune (5ab).

15. Circuit (1) selon l'une des revendications précédentes, dans lequel le circuit (1) présente un corps conducteur de chaleur supplémentaire (4), qui est disposé sur le côté de la carte de circuits imprimés (2) opposé à la source de lumière (3) et est relié thermiquement avec le côté de la carte de circuits imprimés (2) sur lequel est disposée ladite au moins une source de lumière (3) au moyen d'au moins un trou d'interconnexion (6) rempli de brasure traversant la carte de circuits imprimés (2).

16. Circuit (1) selon l'une des revendications précédentes, dans lequel la carte de circuits imprimés (2) est faite de substrat FR-4 ou est réalisée sous la forme d'une carte de circuits imprimés IMS (2).

17. Dispositif d'éclairage comportant au moins un circuit (1) selon l'une des revendications précédentes.

18. Phare, en particulier phare de véhicule automobile, comportant un circuit (1) selon l'une des revendications 1 à 16 et/ou un dispositif d'éclairage selon la revendication 17.
